Europäisches Patentamt

European Patent Office

Office européen des brevets

(19)

(11) Numéro de publication : **0 073 870**
**B1**

# (12) FASCICULE DE BREVET EUROPÉEN

(45) Date de publication du fascicule du brevet :
**30.12.86**

(21) Numéro de dépôt : **81430029.9**

(22) Date de dépôt : **08.09.81**

(51) Int. Cl.⁴ : **H 03 K   5/04**, H 03 K   5/153,
H 03 K   3/284

(54) **Multivibrateur monostable intégré sans condensateur.**

(43) Date de publication de la demande :
**16.03.83 Bulletin 83/11**

(45) Mention de la délivrance du brevet :
**30.12.86 Bulletin 86/52**

(84) Etats contractants désignés :
**DE FR GB**

(56) Documents cités :
**ELECTRONICS LETTERS, vol.3, no.4, avril 1967, Hitchin Herts (GB), R.E. HAYES: "Step-recovery action in transistors", page 151**
**TECHNISCHE RUNDSCHAU, vol.68, no.51, 14 décembre 1976, Berne (CH), P. BLOMEYER: "Kleines LSL-Praktikum", pages 9,11**
**J. Markus: "Modern Electronic Circuits Reference Manual", 1980, McGraw Hill, New York, US, page 775**

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Bonnet, Yves Aimé Jean José**
**Villa Jo-Aimée 135 Avenue H. Brun**
**F-06700 - Saint Laurent Du Var (FR)**

(74) Mandataire : **Klein, Daniel Jacques Henri**
**Compagnie IBM France Département de Propriété Intellectuelle**
**F-06610 La Gaude (FR)**

## Description

La présente invention se rapporte au domaine des circuits de commutation intégrés à semiconducteurs et plus particulièrement à un multivibrateur monostable intégré sans condensateur.

Les multivibrateurs monostables sont des circuits qui en réponse à une impulsion d'entrée (par exemple en provenance d'une horloge) fournissent une impulsion, synchronisée sur le flanc montant ou descendant de l'impulsion d'entrée, et d'une largeur déterminée par leurs paramètres propres et donc indépendante de la largeur de l'impulsion d'entrée. De façon bien connue, la largeur de l'impulsion est déterminée soit par la charge d'un condensateur dans un réseau R.C., soit par la longueur d'une ligne à retard.

Avec la tendance actuelle vers une miniaturisation, toujours plus poussée, des circuits de type VLSI (Very Large Scale Integration), ces composants sont d'une intégration difficile. Les inductances ne sont pratiquement pas intégrables, il faut donc des réseaux R.C. (résistance-capacité) multiples pour réaliser les lignes à retard. Dans tous les cas on revient donc à intégrer des condensateurs sur la puce de silicium. Malheureusement l'intégration de condensateurs selon les technologies intégrées monolithiques pose de nombreux problèmes : d'abord elle est limitée en valeur ; pratiquement il est difficile de dépasser 15 pf, en effet une capacité de 100 pf par exemple, nécessite une surface de silicium de l'ordre de 10 mm$^2$ c'est-à-dire pratiquement toute la surface d'une puce standard. En outre, des valeurs de capacité supérieures à 15 pf peuvent être la source de problèmes en fiabilité (claquage des condensateurs en raison de la présence de trous d'épingle dans l'oxyde).

A l'heure actuelle la solution universellement employée, consiste à utiliser un circuit intégré classique, type 555, auquel on associe un condensateur extérieur, l'ensemble assurant la fonction désirée d'un monostable. Cette solution présente évidemment tous les inconvénients dus à la présence de cette capacité discrète extérieure : perte de place, nécessité de prévoir une broche de sortie du circuit intégré à cet effet, etc.

Un autre mode de réalisation est décrit dans l'article de P. Blomeyer, publié dans la revue Technische Rundschau, Vol. 68, N° 51, 14 décembre 1976 à Berne (CH), en référence aux figures 21 et 22. On y trouve la description d'un multivibrateur monostable constitué par une porte logique NON-OU (G2) associée à un circuit de maintien (G1). Ce dernier est formé d'une porte OU associé à un condensateur discret CN.

Le besoin d'un circuit monostable entièrement réalisé sous forme monolithique, et à forte densité d'intégration, et sans condensateur se fait donc ressentir dans l'industrie électronique aujourd'hui.

La présente invention telle qu'elle est revendiquée a pour objet d'éliminer tous les inconvénients précités. Elle résout le problème en fournissant un multivibrateur monostable intégré original dans sa structure mais classique dans sa fonction, c'est-à-dire qui, en réponse à une impulsion rectangulaire de largeur T fournit une impulsion rectangulaire, synchronisée, de largeur $T + \tau$ ; $\tau$ étant un délai prédéterminé ajustable dans un mode de réalisation particulier.

Ce multivibrateur monostable intègre, très simple, évite l'emploi classique d'un condensateur et de sa charge pour l'obtention du délai $\tau$. Pour cela il utilise le retard au blocage d'un transistor bipolaire classique préalablement saturé. Ce phénomène de retard au blocage est en lui-même connu. On pourra se référer par exemple à l'ouvrage de J. Markus « Modern Electronic Circuits Reference Manual », 1980 Mc. Graw Hill, New York, page 775 (2$^e$ circuit). Dans ce circuit connu, la saturation d'un transistor monté en émetteur commun est mise en œuvre de manière à obtenir sur le collecteur une impulsion allongée par rapport à l'impulsion d'entrée.

Le multivibrateur monostable intégré selon l'invention, ne comportant pas de condensateur, peut être entièrement réalisé sur une infime portion d'une microplaquette de silicium selon les technologies classiques de fabrication des circuits intégrés, avec tous les avantages bien connus que procure l'intégration.

Un mode de réalisation préféré de l'invention est décrit de façon plus détaillée dans ce qui suit et illustré à l'aide des dessins donnés en annexe.

La figure 1A représente un multivibrateur monostable réalisé totalement en technologie bipolaire de type NPN, qui associe un circuit NON-OU au circuit de maintien de l'invention.

La figure 1B représente le bloc diagramme schématique du multivibrateur monostable montré sur la figure 1A.

La figure 2 représente les diagrammes d'impulsion pris en différents points du multivibrateur monostable montré sur la figure 1A.

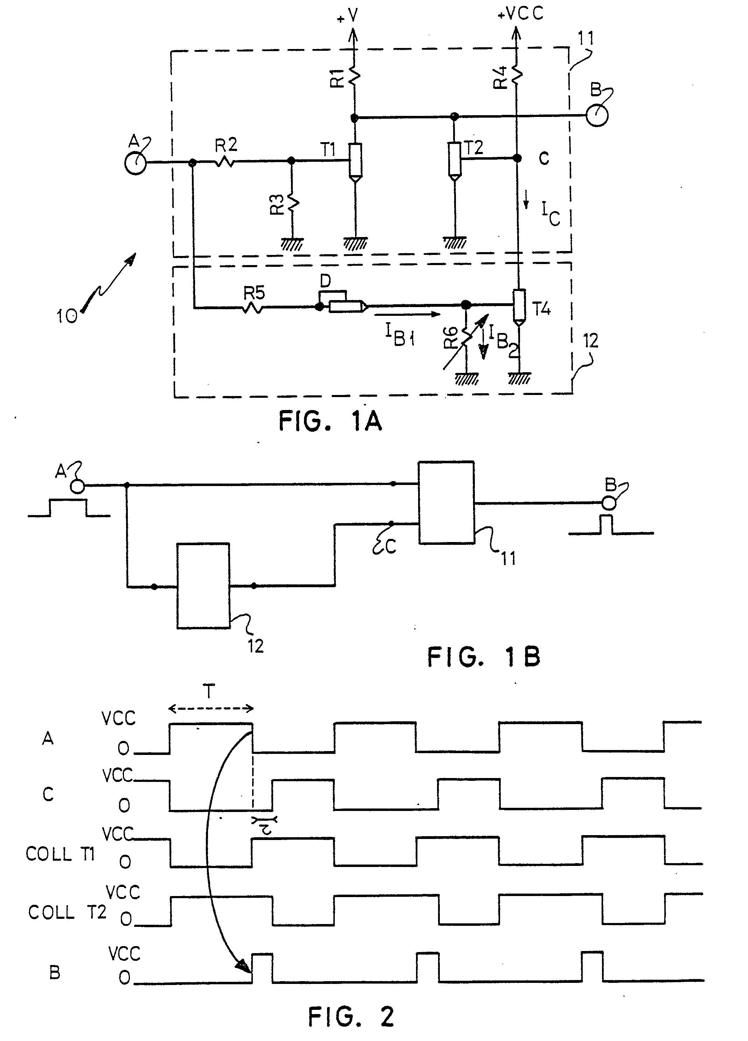

Sur les figures 1A et 1B on a représenté un multivibrateur monostable 10 conforme à la présente invention. Il se compose d'un circuit NON-OU 11 classique, qui reçoit le signal d'horloge (appliqué à la borne A) sur une première entrée et la sortie du circuit de maintien 12 sur la seconde entrée (référence C). Le signal de sortie est disponible sur la borne B. Le circuit de maintien reçoit également le signal d'horloge comme signal d'entrée.

Le circuit NON-OU 11 est réalisé de manière classique en réunissant les collecteurs des transistors T1 et T2 à une résistance commune R1 reliée à la tension d'alimentation VCC. Les bases des transistors T1 et T2 comportent respectivement les résistances de polarisation R2, R3 et R4. Le circuit de maintien 12 est constitué d'une résistance R5, d'une diode antiretour D (réalisée à partir d'un transistor T3 dont la

0 073 870

jonction collecteur base a été court-circuitée) et d'un transistor T4 associé à une résistance R6 qui intervient comme résistance de polarisation mais surtout joue le rôle de décharge de charges stockées dans la base du transistor T4 quand ce dernier est saturé, comme on le verra ci-après.

Le fonctionnement du circuit 10 peut être compris à l'aide de la figure 2. On a représenté sur cette figure les potentiels aux points A (entrée du signal d'horloge), au point B (sortie du multivibrateur), au point C (sortie du circuit de maintien) et les potentiels des collecteurs des transistors T1 et T2 considérés comme seuls, c'est-à-dire comme si ces collecteurs n'étaient pas réunis, et chargés chacun par une résistance de charge R1.

Quand un niveau haut (par exemple $V_{cc}$) est appliqué par le signal d'horloge sur l'entrée A, le transistor $T_1$ est rendu immédiatement conducteur. Le potentiel du collecteur de T1 passe donc de $V_{cc}$ à 0 volt. Pour la simplification du dessin, les retards dus aux temps d'ouverture ($t_{off}$) et de fermeture ($t_{on}$) qui sont de l'ordre de 20 et 10 ns respectivement ne sont pas représentés. L'application de ce niveau haut amène également la saturation immédiate du transistor T4, le courant de saturation de sa base est pratiquement défini par

$$I_{B1} = \frac{V_{cc} - V_D - (V_{EB}) T4}{R5}$$

En effet on a R6 >> R5 expression dans laquelle $V_D$ représente la chute de potentiel dans la diode D et $(V_{BE})T4$ la chute de tension aux bornes de la jonction émetteur-base de T4. Le gain en saturation $\beta(h_{FE})$ ou gain en courant statique du transistor T4 est défini par le rapport

$$\frac{I_{c_{max}}}{I_{B1}}$$

pour le transistor T4 à la saturation avec

$$I_{c_{max}} = \frac{V_{cc}}{R4}$$

soit pratiquement $\beta \# R4/R5$. La saturation du transistor T4 entraîne la mise à la masse de la base du transistor T2 et donc son blocage très rapide. La figure 2 montre bien la montée du potentiel sur le collecteur de T2 considéré comme seul. Quand le signal d'horloge repasse au niveau bas après un temps T, le transistor T1 se bloque rapidement en raison de la faible résistance de polarisation de sa base (R2 en parallèle avec R3) et le potentiel du collecteur du transistor T1 remonte rapidement à $V_{cc}$. Mais les charges (porteurs minoritaires) stockées dans la base du transistor T4 fortement saturé qui ne peuvent s'écouler vers la borne A (qui est alors au potentiel de la masse) en raison de la présence de la diode antiretour D, se déchargent dans la résistance R6. Cette dernière commande donc le délai de blocage du transistor T4 de façon contrôlée. Pour le transistor T4 le temps de blocage $t_{off}$ qui est égal à la somme du temps de stockage $t_s$ et du temps de descente $t_f$ est important surtout en raison de $t_s$. En effet ce temps de stockage $t_s$ est donné par la relation connue

$$t_s = \tau_s \, \mathrm{Log}_n \left[ \frac{|\,I_{B1}\,| + |\,I_{B2}\,|}{|\,\frac{I_{c_{max}}}{\beta}\,| + |\,I_{B2}\,|} \right] \qquad (1)$$

relation dans laquelle $\tau_s$ est la constante de temps de désaturation et $I_{B2}$ le courant de blocage du transistor T4 avec

$$I_{B2} = \frac{(V_{BE}) T4}{R6}$$

$I_{B1}$ dépend, comme on l'a vu essentiellement de R5. Les paramètres $\tau_s$, $\beta$ sont déterminés par la technologie bipolaire utilisée. Le temps de stockage $t_s$ étant fonction d'un certain nombre de paramètres, notamment de R6, pourra être ajusté à la valeur désirée sans difficulté.

Il est intéressant de noter que le phénomène de stockage des charges dans la base et donc l'existence du temps de stockage $t_s$ inhérent à tout transistor est généralement considéré comme très défavorable pour le fonctionnement des circuits, puisqu'il réduit la vitesse de commutation, aussi jusqu'à présent on a surtout cherché à le réduire (par exemple, par une diode Schottky, en parallèle sur la jonction collecteur-base ou encore par la traditionnelle capacité disposée en parallèle sur la résistance d'attaque de la base).

Après un temps $\tau$ voisin de $t_s$, T4 se bloque, ce qui cause la conduction immédiate du transistor T2. La sortie B correspond physiquement au point commun des collecteurs des transistors T1 et T2. Le diagramme des impulsions au point B s'obtient donc en faisant une fonction OU entre les diagrammes des tensions des collecteurs des transistors T1 et T2.

3

Sur la figure 2 on reconnaît donc l'obtention d'une impulsion de largeur $\tau$ déterminée et ajustable, synchronisée sur l'arrêt de la commande, c'est-à-dire sur le flanc descendant de l'impulsion d'horloge, qui est caractéristique du fonctionnement du multivibrateur monostable.

Exemple : avec une technologie bipolaire NPN classique qui fournit des transistors avec les caractéristiques suivantes : $fT \geqslant 400$ MHz, $BV_{CEO} = 13$ V, $\beta \geqslant 30$, en choisissant pour T4 un transistor de type 10 mA et pour T1, T2 et T3 des transistors type 3 mA on obtient : $\tau_s = 95$ ns pour le transistor T4 et $V_D = (V_{BE})T4 = 0,7$ V, en choisissant $R5 = 4$ K, $R6 = 30$ k et $R4 = 8$ k on trouve par la relation (1) ci-dessus $t_s = 290$ ns soit $t_s \# 300$ ns.

Avec un monostable classique chargé par une résistance de 10 k, ce délai sera obtenu théoriquement avec $C = 30$ pf, on fait 50 pf soit 4,5 mm$^2$ de silicium.

Le circuit 10 peut être réalisé soit avec des technologies mixtes de type BIFET, soit en technologie bipolaire ; le transistor T4 étant comme on l'a vu toujours de type bipolaire. Ce circuit est indépendant de la technologie bipolaire utilisée qui fixe les paramètres du transistor T4, dans la mesure où l'on peut ajuster la valeur de la résistance R6 pour obtenir le délai $\tau$ désiré. La transposition de ce circuit réalisé avec des transistors NPN, à une version utilisant des transistors PNP est immédiate pour l'homme de l'art et conduit à la génération d'impulsions qui sont synchronisées sur le flanc montant des impulsions d'horloge, correspondant encore à l'arrêt de la commande.

Le multivibrateur monostable 10 trouve application dans tous les cas où il faut produire une autre impulsion, de durée déterminée $\tau$, synchronisée sur le flanc descendant (ou montant) d'une impulsion d'horloge, il peut donc servir de générateur d'impulsions, de circuit de mise en forme, de détecteur de transition, de circuit d'élaboration de délai, etc.

## Revendications

1. Multivibrateur monostable intégré (10, Fig. 1A) comportant un circuit NON-OU à deux entrées (11) dont une première entrée est reliée à la borne d'entrée (A) du monostable qui reçoit un signal d'entrée constitué par une série d'impulsions de commande de durée T, dont la seconde entrée (C) est reliée à ladite borne d'entrée du monostable, à travers un circuit de maintien (12), et dont la sortie est reliée à la borne de sortie (B) du monostable pour fournir des impulsions de durée synchronisée sur le flanc arrière de ladite impulsion de commande de durée caractérisé en ce que ledit circuit de maintien (12) comporte un transistor bipolaire (T4) monté en émetteur commun dont le collecteur chargé par une résistance de charge R4 est relié à ladite seconde entrée (C) du circuit NON-OU et dont la base est reliée d'une part à ladite entrée (A) du monostable à travers une résistance (R5) et une diode antiretour (D), et d'autre part à l'émetteur par une résistance de décharge (R6) de telle sorte que ledit transistor reste saturé après la fin de l'impulsion de commande pendant un temps $\tau$, pratiquement égal au temps de stockage $t_s$ du transistor, ce retard au blocage rendant inutile l'emploi d'un condensateur dans ledit circuit de maintien.

2. Multivibrateur selon la revendication 1 dans lequel ladite résistance de décharge (R6) est ajustable pour l'obtention du délai $\tau$ désiré.

## Claims

1. An integrated monostable multivibrator (10, Fig. 1A) comprising a dual-input NOR circuit (11) a first input of which is connected to the input terminal (A) of the monostable to which an input signal consisting of a sequence of control pulses of width T is applied and the second input (C) of which is connected to said input terminal of the monostable, through a holding circuit (12), and the output of which is connected to the output terminal (B) of the monostable to provide pulses synchronized with the trailing edge of said control pulse, characterized in that said holding circuit (12) comprises a bipolar transistor (T4) in a common emitter configuration the collector of which is loaded by a load resistor R4 and connected to said second input (C) of said NOR circuit and the base of which is connected, on the one hand, to said input (A) of the monostable through a resistor (R5) and a blocking diode (D), and on the other hand, to the emitter through a discharge resistor (R6), so that said transistor remains in saturation, after the control pulse has been removed, for a time interval $\tau$ practically equal to the storage time $t_s$ of the transistor, whereby the delayed turn-off thereof makes it unnecessary to use a capacitor in said holding circuit.

2. A multivibrator according to claim 1, wherein the value of said discharge resistor (R6) can be adjusted to provide the desired time interval $\tau$.

## Patentansprüche

1. Integrierter monostabiler Multivibrator (10, Abb. 1A), mit einer NEIN-ODER-Schaltung mit zwei Eingängen (11), von denen ein erster mit der Eingangsklemme (A) des monostabilen Multivibrators verbunden ist, der ein Eingangssignal empfängt, bestehend aus einer Reihe von Steuerimpulsen der

**0 073 870**

Dauer T, und deren zweiter Eingang (C) über eine Halteschaltung (12) mit der besagten Eingangsklemme des monostabilen Multivibrators verbunden ist, und deren Ausgang mit der Ausgangsklemme (B) des monostabilen Multivibrators verbunden ist, um Impulse abzugeben, deren Dauer auf die fallende Flanke des besagten Dauer-Steuerimpulses synchronisiert ist, dadurch gekennzeichnet, dass die besagte Halteschaltung (12) einen zweipoligen Transistor (T4) in Emitterschaltung enthält, dessen Collector über einen Last-widerstand R4 geladen wird, und an den besagten zweiten Eingang (C) der NEIN-ODER-Schaltung gelegt ist, und dessen Basis einerseits mit dem besagten Eingang (A) des monostabilen Multivibrators über einen Widerstand (R5) und eine in Rückflussrichtung gesperrte Diode (D), und andererseits mit dem Emitter über einen Entladungswiderstand (R6) so verbunden ist, dass der besagte Transistor nach dem Ende des Steuerimpulses während einer Zeit $\tau$ gesättigt bleibt, die praktisch gleich mit der Speicherzeit $t_s$ des Transistors ist, sodass die Sperrverzögerung die Verwendung eines Kondensators in der besagten Haltungsspannung überflüssig macht.

2. Multivibrator nach Anspruch 1, in dem der besagte Entladewiderstand (R6) verstellbar ist, um die gewünschte Dauer $\tau$ zu erreichen.

FIG. 1A

FIG. 1B

FIG. 2